# EUROPEAN PATENT SPECIFICATION

(11) **EP 2 851 698 B1**
(45) Date of publication and mention of the grant of the patent: **21.07.2021**
(21) Application number: 13184962.2
(22) Date of filing: 18.09.2013
(51) Int. Cl.: G01R 31/34, H02P 29/024, H02P 29/02

(54) **A method for detecting a fault in an electrical machine**
Verfahren zur Erkennung eines Fehlers in einer elektrischen Maschine
Procédé de détection d'une panne d'une machine électrique

(43) Date of publication of application: 25.03.2015
(73) Proprietor: ABB Schweiz AG, 5400 Baden (CH)
(72) Inventor: Särkimäki, Ville, 00390 Helsinki (FI)
(74) Representative: Kolster Oy Ab

(56) References cited:
- EP-A2- 1 418 655
- DE-U1-202010 000 374
- US-A1- 2004 145 838
- US-A1- 2011 025 371
- US-A1- 2012 001 580
- US-A1- 2013 030 742
- BYUNGHWAN KIM ET AL: "Automated Detection of Rotor Faults for Inverter-Fed Induction Machines Under Standstill Conditions", IEEE TRANSACTIONS ON INDUSTRY APPLICATIONS, IEEE SERVICE CENTER, PISCATAWAY, NJ, US, vol. 47, no. 1, 1 January 2011 (2011-01-01), pages 55-64, XP011342201, ISSN: 0093-9994, DOI: 10.1109/TIA.2010.2090931
- GRUBIC S ET AL: "A survey of testing and monitoring methods for stator insulation systems in induction machines", CONDITION MONITORING AND DIAGNOSIS, 2008. CMD 2008. INTERNATIONAL CONFERENCE ON, IEEE, PISCATAWAY, NJ, USA, 21 April 2008 (2008-04-21), pages 196-203, XP031292477, ISBN: 978-1-4244-1621-9
- Jack R. Nicholas: "Off-line and on-line motor electrical monitoring and condition analysis: payoffs and problems", Proceedings of a Joint Conference, Mobile, Alabama, April 22-26, 1996, 22 April 1996 (1996-04-22), pages 1-10, XP055104681, Retrieved from the Internet: URL:http://www.dtic.mil/dtic/tr/fulltext/u 2/p010195.pdf [retrieved on 2014-02-27]

## Description

### TECHNICAL FIELD

The present invention relates to a non-invasive method for detecting a fault in an electrical machine.

### BACKGROUND ART

Condition of electrical machines is many times monitored in order to prevent unexpected failures. There is a plurality of monitoring methods that can be divided into different categories depending on how they are executed. Depending on whether the machine needs to be opened or not, the methods can be divided into invasive and non-invasive methods. The methods can further be divided into online and offline methods (depending on whether the normal operation of the machine needs to interrupted for the monitoring), and continuous and non-continuous methods. An ideal monitoring method would be a non-invasive and continuous online method that is based on an easily measurable physical phenomenon and can detect in a reliable way all thinkable faults. However, depending on the fault, the available methods can be far from the ideal. For example, even when a non-invasive online method exists, the results may require lots of interpretation and the reliability may be worse than desired.

WO201245353A1 discloses a method for detecting a missing stator slot wedge in an electrical machine. EP2518456A1 discloses a method for monitoring demagnetization of permanent magnets in a synchronous machine. EP2541217A1 discloses a method for identifying the following faults in an electrical machine: a broken rotor bar, a dynamic eccentricity, a static eccentricity, an inter-turn short circuit and an inter-coil short circuit. All the methods disclosed in the aforementioned patent applications are non-invasive methods that can be applied continuously online. However, depending on the machine type, on the normal operation conditions of the machine, and on the threshold values that are chosen to indicate a fault, the respective method may not always give reliable results. As a consequence, false alarms can be triggered, or, if the threshold values are increased to avoid false alarms, a fault can go undetected.

Additional fault detection methods are known as follows. EP1418655A2 discloses a method for locating a speed sensitive ground condition in a field winding of an electromagnetic synchronous machine. Byunghwan Kim et al, "Automated Detection of Rotor Faults for Inverter-Fed Induction Machines Under Standstill Conditions" discloses an automated technique for testing voltage source inverter-fed squirrel-cage induction machines at a standstill for rotor faults. Grubic S. et al, "A survey of testing and monitoring methods for stator insulation systems in induction machines" discloses an in-depth literature review of more than 20 existing methods to assess the phase-to-ground, phase-to-phase, and turn-to-turn insulation conditions. Jack R. Nicholas, "Off-line and on-line motor electrical monitoring and condition analysis: payoffs and problems" discloses motor electrical condition monitoring and analysis methods.

There remains a desire to improve the reliability of the existing fault detection methods in electrical machines.

### SUMMARY OF THE INVENTION

One object of the invention is to provide an improved method for detecting a fault in an electrical machine. The improved method shall be more reliable than the previously known methods.

This object is achieved by the method according to the appended claim 1, and by the frequency converter according to the appended claim 12. The invention is based on the realization that a fault indication obtained with a less reliable but a convenient method can be confirmed by applying a more reliable but a less convenient method. The combination of the two methods results in a reliable method with a good ability to detect faults without triggering too many false alarms.
According to a first aspect of the invention, there is provided a method for detecting a fault in an electrical machine. The method comprises the steps of: carrying out at least one first measurement on the machine during a normal operation of the machine to obtain a first set of values; analysing the first set of values to obtain a first fault indication; interrupting, as a consequence of obtaining the first fault indication, the normal operation of the machine; choosing, on the basis of the type of the first fault indication, a second measurement from a plurality of alternative measurements; carrying out the second measurement on the machine when the normal operation of the machine is interrupted to obtain a second set of values; analysing the second set of values to obtain a second fault indication; and determining, on the basis of whether the second fault indication is obtained or not, whether the fault is present or not. The combination of the first and the second fault indications enables detecting faults reliably without triggering too many false alarms.

The method further comprises the steps of: resuming, as a consequence of not obtaining the second fault indication, the normal operation of the machine; and changing a condition of obtaining the first fault indication. By this measure the influence of the false alarm on an installation the machine is connected to is minimized and another false alarm is prevented from being triggered.

According to one embodiment of the invention, the first measurement comprises one of the following: a phase current measurement in a stator winding, a vibration measurement, a phase voltage measurement and a speed measurement. These measurements are found out to be convenient online measurements providing first indications of different types of faults.

According to one embodiment of the invention, the fault is one of the following: an inter-turn short circuit in a stator winding, a broken rotor bar, a bearing fault and a cooling fault. The present method is particularly well adapted to detect the named faults.

According to one embodiment of the invention, the step of analysing of the first set of values comprises transformation of the first set of values into a frequency domain. Analysis in a frequency domain is particularly well adapted for online measurement results as many types of faults can be detected from current and vibration spectra during normal operation of the machine.

According to one embodiment of the invention, the second measurement is carried out when the machine is at standstill. Measurement at standstill is particularly well adapted for confirming a fault as many of the most reliable analysing methods assume measurements done at standstill. According to one embodiment of the invention, the method further comprises the step of injecting a test signal in a winding of the machine, and the second set of values comprises a response to the test signal. Measuring a response on a test signal is particularly well adapted for confirming a fault as many of the most reliable analysing methods assume excitation of the stator winding.

According to one embodiment of the invention, the method further comprises the step of carrying out a reference measurement on the machine when the machine is new or otherwise presumably fault free to obtain a set of reference values. By this measure access to reference values is ensured, which improves the reliability of the used analysing methods.

According to one embodiment of the invention, the method further comprises the step of comparing the first set of values and/or the second set of values with the set of reference values. By this measure the reliability of the used analysing methods is improved.

According to one embodiment of the invention, at least one method step is executed automatically by a computer program running within a frequency converter operating the machine. By this measure the fault detection can be rendered continuous without the need of interaction by an operator.

According to one embodiment of the invention, the method further comprises the step of providing, as a consequence of obtaining the first fault indication, a first warning. By this measure the operator is informed about eventual problems with the machine.

According to one embodiment of the invention, the method further comprises the step of providing, as a consequence of obtaining the second fault indication, a second warning. By this measure the operator is informed about apparent problems with the machine.

According to a second aspect of the invention, there is provided a frequency converter for operating an electrical machine. The frequency converter comprises a computer program configured to execute the method steps of the method disclosed hereinbefore. By integrating the fault detection program within the frequency converter no additional hardware device is needed for executing the fault detection function.

The frequency converter further comprises a measuring instrument for carrying out the first and/or the second measurement. By integrating the measuring instrument with the frequency converter no separate hardware device is needed for carrying out the measurements.

According to one embodiment of the invention, the frequency converter further comprises means for injecting a test signal in a winding of the machine. By integrating the means for injecting the test signal with the frequency converter no separate hardware device is needed for carrying out the excitation of the winding.

### BRIEF DESCRIPTION OF THE DRAWINGS

The invention will be explained in greater detail with reference to the accompanying drawings, wherein
- figure 1: shows a flow chart illustrating one embodiment of the invention,
- figure 2: shows a measurement result relating to obtaining a first fault indication, and
- figure 3: shows a measurement result relating to obtaining a second fault indication.

### DESCRIPTION OF PREFERRED EMBODIMENTS

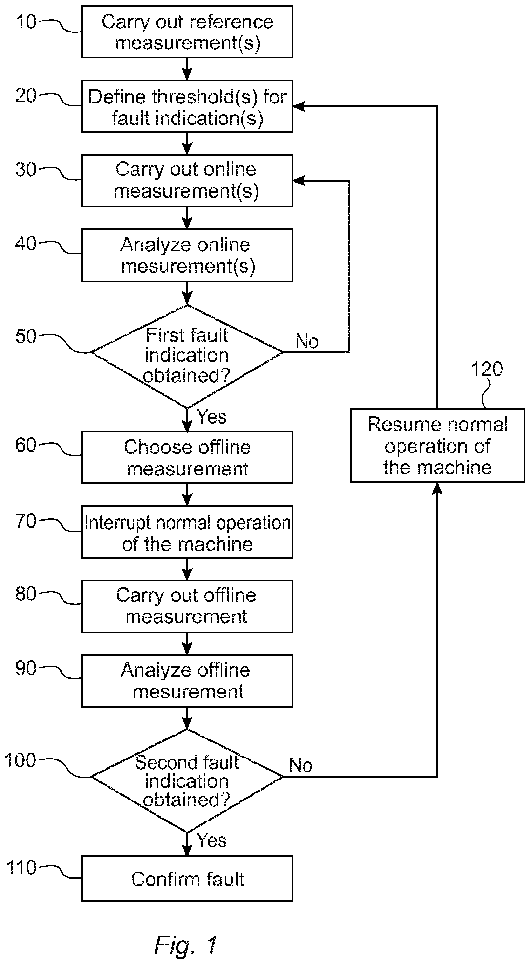

Referring to figure 1, a flow chart illustrating a method according to the present invention is shown. At a first step 10 a reference measurement or reference measurements for an electrical machine are carried out. For the sake of this example it can be assumed that the electrical machine is an induction motor, and that one type of a fault to be detected is a broken rotor bar. The reference measurements can comprise a phase current measurement in a stator winding carried out when the motor is new and operating at full load. The reference measurements can further comprise resistance measurements including measuring responses to an injected test signal. The test signal can comprise 10 Hz, 50 Hz and 100 HZ excitation signals injected at different electrical angles of the stator winding when the motor is at standstill. The voltage of the test signal can be chosen so that the stator current is about 20% of the rated current. The reference values obtained from the reference measurements are reflecting a response of a fault free motor.

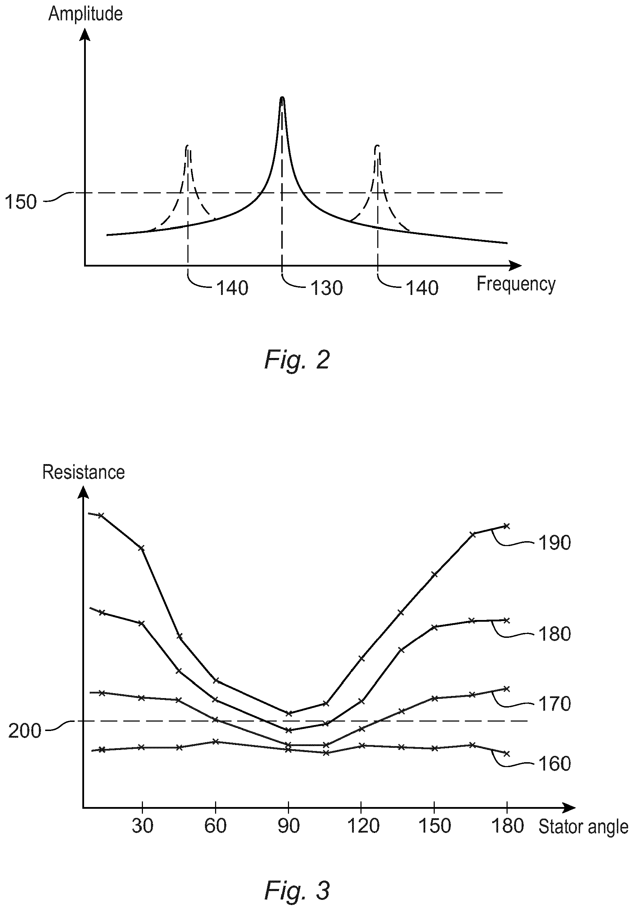

At a second step 20 conditions for obtaining fault indications are defined. Firstly, a first threshold value 150 (figure 2) which, when exceeded, triggers a first fault indication, is defined. In the present example the entity to be observed is an amplitude of a stator current at certain harmonic frequency that is known to indicate a broken rotor bar. Figure 2 shows a spectrum of a stator current measurement. The current has one fundamental harmonic frequency 130 at the supply frequency of the motor. There are two side frequencies 140 the existence of which indicates at least one broken rotor bar. The first threshold value 150 is chosen appropriately on the basis of previous experiences about how broken rotor bars affect the current frequencies. For example, the first threshold value 150 can be chosen to be two times the corresponding value in a healthy machine on a decibel scale. For the purpose of frequency analysis according to figure 2 the measured stator current values are brought into a frequency domain e.g. by using a Fourier transform.

Further at the second step 20 of figure 1, a second threshold value 200 (figure 3) for obtaining a second fault indication is defined. In the present example the entity to be observed is resistance at different electrical angles of the motor. Figure 3 shows experimental results of a measurement on a response to a corresponding test signal as that explained above. The first resistance curve 160 represents a healthy motor, and the second, third and fourth resistance curves 170, 180, 190 represent motors with one, two and three broken rotor bars, respectively. The second threshold value 200 is chosen appropriately on the basis of the experimental results on how broken rotor bars affect the resistance. For example, the second threshold value 200 can be chosen to be in the middle of the average value of the first resistance curve 160 and the maximum value of the second resistance curve 170.

Yet further at the second step 20 of figure 1, corresponding conditions for obtaining first and second fault indications as described above for the broken rotor bar are defined for all types of faults to be detected. Such other types of faults may include an inter-turn short circuit in a stator winding, a bearing fault and a cooling fault.

At a third step 30 a stator current measurement on the motor is carried out during a normal operation of the motor. A first set of values is obtained from this online measurement. The first set of values is further analysed at a fourth step 40 where the first set of values is first transformed into a frequency domain and then the current amplitudes at the side frequencies 140 are compared with the previously defined first threshold value 150 (cf. figure 2). If none of the current amplitudes at the side frequencies 140 exceeds the first threshold value 150, then no first fault indication at a fifth step 50 is obtained, and a new online measurement at the third step 30 is carried out after a predefined time delay. If at least one of the current amplitudes at the side frequencies 140 does exceed the first threshold value 150, then a first fault indication at the fifth step 50 is obtained, and as a consequence an offline measurement is applied.

Again, corresponding online measurements as described above for the broken rotor bar are carried out 30 and analysed 40 for all types of faults to be detected. The online measurements are not limited to phase current measurements in a stator winding, but may also include vibration measurements, phase voltage measurements, speed measurements, etc. If a first fault indication is obtained as a result of any of the online measurements and the subsequent analyses, an offline measurement is applied.

At a sixth step 60 an appropriate offline measurement is chosen from a plurality of alternative measurements. The choice is based on the type of the first fault indication. In the present example (the first fault indication indicates a broken rotor bar) a resistance measurement measuring responses to an injected test signal is chosen to determine the presence of the alleged broken rotor bar. Because of the requirements of the chosen measurement the normal operation of the motor is interrupted at a seventh step 70 by bringing the motor to standstill.

At an eighth step 80 a corresponding test signal as that explained above is injected in the motor, and a measurement on a response to the test signal is carried out to find out resistance at different electrical angles of the motor. A second set of values corresponding to the resistance curves 160, 170, 180, 190 as shown in figure 3 is obtained from this offline measurement. The second set of values is further analysed at a ninth step 90 where it is compared with the previously defined second threshold value 200. If none of the resistance values exceeds the second threshold value 200, then no second fault indication at a tenth step 100 is obtained, and the normal operation of the motor is resumed at a twelfth step 120. The condition of obtaining the first fault indication is changed by increasing the first threshold value 150 at the second step 20 to prevent another false alarm from being triggered. If at least one of the resistance values does exceed the second threshold value 200, then a second fault indication at the tenth step 100 is obtained. As a consequence of obtaining the second fault indication, the fault is confirmed at an eleventh step 110 and it is determined that the fault is present.

If the first fault indication would indicate another type of fault than a broken rotor bar, such as for example an inter-turn short circuit in a stator winding, then eventually another offline measurement would be chosen. For example, an indication of an inter-turn short circuit in a stator winding can be obtained with an online measurement measuring stator phase current and a subsequent analysis wherein the entity to be observed is current amplitude in time domain (unbalance between current amplitudes in different phases indicates a stator inter-turn fault). Alternatively, an online measurement according to EP2541217A1 can be used. According to the present invention, when a first fault indication indicating an inter-turn short circuit in a stator winding is obtained at the fifth step 50, an appropriate offline measurement capable of detecting that fault is chosen at the step 60. In the present example the offline measurement used to determine the presence of the alleged inter-turn short circuit in a stator winding may include measuring current responses to a 50 Hz test signal of 15 V voltage injected in the motor at different electrical angles of the stator winding when the motor is at standstill. The entity to be observed is an amplitude of the generated current. If the measured values deviate from the corresponding reference measurements and if a corresponding predefined threshold value is undershot (the current amplitude decreases when this type of fault is present), then the inter-turn short circuit in a stator winding can be confirmed.

It can also happen that the offline measurement does not need to be carried out when the machine is at standstill. Depending on the requirements of chosen measurement, the offline measurement can also be carried out when the machine is at quasi standstill, is executing a certain speed ramp, or is executing any other movement that is not considered as normal operation of the machine. In the context of the present invention the machine is to be considered to assume normal operation when it rotates fast enough to fulfil its primary function in an installation it is connected to.

All the above mentioned steps 10-120 can be executed automatically by a computer program running within a frequency converter operating the motor. The frequency converter preferably comprises a measuring instrument or measuring instruments for carrying out 30, 80 the different measurements, a test signal injecting means for injecting the test signal, and enough computing power for analysing 40, 90 the measurement results. Furthermore, the frequency converter preferably comprises a display means or another suitable means for informing an operator of the motor about an eventual fault.

The invention is not limited to the embodiments shown above, but the person skilled in the art may modify them in a plurality of ways within the scope of the invention as defined by the claims. Thus, the invention is not limited to induction motors, but may also be applied to other types of electrical motors and also other types of electrical machines such as generators.

## Claims

1. A method for detecting a fault in an electrical machine, the method comprising the steps of:
- carrying out (30) at least one first measurement on the machine during a normal operation of the machine to obtain a first set of values;
- analysing (40) the first set of values to obtain a first fault indication;
- interrupting (70), as a consequence of obtaining the first fault indication, the normal operation of the machine;
- choosing (60), on the basis of the type of the first fault indication, a second measurement from a plurality of alternative measurements;
- carrying out (80) the second measurement on the machine when the normal operation of the machine is interrupted to obtain a second set of values;
- analysing (90) the second set of values to obtain a second fault indication; and
- determining, on the basis of whether the second fault indication is obtained or not, whether the fault is present or not;
the method being **characterized by** comprising the steps of:
- as a consequence of not obtaining the second fault indication, resuming (120) the normal operation of the machine and changing (20) a condition (150) of obtaining the first fault indication such that another false first fault indication is prevented from being obtained.

2. The method according to any of the preceding claims, wherein the first measurement comprises one of the following: a phase current measurement in a stator winding, a vibration measurement, a phase voltage measurement and a speed measurement.

3. The method according to any of the preceding claims, wherein the fault is one of the following: an inter-turn short circuit in a stator winding, a broken rotor bar, a bearing fault and a cooling fault.

4. The method according to any of the preceding claims, wherein the step of analysing (40) of the first set of values comprises transformation of the first set of values into a frequency domain.

5. The method according to any of the preceding claims, wherein the second measurement is carried out (80) when the machine is at standstill.

6. The method according to any of the preceding claims, wherein the method further comprises the step of injecting a test signal in a winding of the machine, and the second set of values comprises a response to the test signal.

7. The method according to any of the preceding claims, the method further comprising the step of: carrying out (10) a reference measurement on the machine when the machine is new or otherwise presumably fault free to obtain a set of reference values.

8. The method according to claim 7, the method further comprising the step of: comparing the first set of values and/or the second set of values with the set of reference values.

9. The method according to any of the preceding claims, wherein at least one method step is executed automatically by a computer program running within a frequency converter operating the machine.

10. The method according to any of the preceding claims, the method further comprising the step of: providing, as a consequence of obtaining the first fault indication, a first warning.

11. The method according to any of the preceding claims, the method further comprising the step of: providing, as a consequence of obtaining the second fault indication, a second warning.

12. A frequency converter for operating an electrical machine, the frequency converter comprising at least one measuring instrument for carrying out the first and the second measurements according to any of the preceding claims, **characterized in that** the frequency converter comprises a computer program configured to execute the method steps of at least one of the preceding claims.

13. A frequency converter according to claim 12, further comprising means for injecting a test signal in a winding of the machine.

## Patentansprüche

1. Verfahren zum Detektieren eines Fehlers in einer elektrischen Maschine, wobei das Verfahren die folgenden Schritte umfasst:
- Durchführen (30) mindestens einer ersten Messung an der Maschine während eines Normalbetriebs der Maschine, um einen ersten Satz von Werten zu erlangen;
- Analysieren (40) des ersten Satzes von Werten, um eine erste Fehleranzeige zu erlangen;
- Unterbrechen (70) des Normalbetriebs der Maschine als Folge des Erlangens der ersten Fehleranzeige;
- Auswählen (60) einer zweiten Messung aus einer Mehrzahl alternativer Messungen auf Grundlage des Typs der ersten Fehleranzeige;
- Durchführen (80) der zweiten Messung an der Maschine, wenn der Normalbetrieb der Maschine unterbrochen ist, um einen zweiten Satz von Werten zu erlangen;
- Analysieren (90) des zweiten Satzes von Werten, um eine zweite Fehleranzeige zu erlangen; und
- Bestimmen, ob der Fehler vorliegt oder nicht, auf Grundlage davon, ob die zweite Fehleranzeige erlangt wird oder nicht;
wobei das Verfahren **gekennzeichnet ist durch** Umfassen der folgenden Schritte:
- als Folge eines Nicht-Erlangens der zweiten Fehleranzeige Fortsetzen (120) des Normalbetriebs der Maschine und Ändern (20) einer Bedingung (150) des Erlangens der ersten Fehleranzeige derart, dass verhindert wird, dass eine weitere falsche erste Fehleranzeige erlangt wird.

2. Verfahren nach einem der vorhergehenden Ansprüche, wobei die erste Messung eine der folgenden umfasst: eine Phasenstrommessung in einer Statorwicklung, eine Schwingungsmessung, eine Phasenspannungsmessung und eine Geschwindigkeitsmessung.

3. Verfahren nach einem der vorhergehenden Ansprüche, wobei der Fehler einer der folgenden ist: ein Windungsschluss in einer Statorwicklung, ein gebrochener Rotorstab, ein Lagerfehler und ein Kühlungsfehler.

4. Verfahren nach einem der vorhergehenden Ansprüche, wobei der Schritt des Analysierens (40) des ersten Satzes von Werten eine Transformation des ersten Satzes von Werten in einen Frequenzbereich umfasst.

5. Verfahren nach einem der vorhergehenden Ansprüche, wobei die zweite Messung durchgeführt wird (80), wenn die Maschine stillsteht.

6. Verfahren nach einem der vorhergehenden Ansprüche, wobei das Verfahren ferner den Schritt des Einspeisens eines Prüfsignals in eine Wicklung der Maschine umfasst und der zweite Satz von Werten eine Antwort auf das Prüfsignal umfasst.

7. Verfahren nach einem der vorhergehenden Ansprüche, wobei das Verfahren ferner den folgenden Schritt umfasst: Durchführen (10) einer Referenzmessung an der Maschine, wenn die Maschine neu oder ansonsten vermutlich fehlerfrei ist, um einen Satz von Referenzwerten zu erlangen.

8. Verfahren nach Anspruch 7, wobei das Verfahren ferner den folgenden Schritt umfasst: Vergleichen des ersten Satzes von Werten und/oder des zweiten Satzes von Werten mit dem Satz von Referenzwerten.

9. Verfahren nach einem der vorhergehenden Ansprüche, wobei mindestens ein Verfahrensschritt von einem Computerprogramm, das in einem Frequenzumrichter, der die Maschine betreibt, läuft, automatisch ausgeführt wird.

10. Verfahren nach einem der vorhergehenden Ansprüche, wobei das Verfahren ferner den folgenden Schritt umfasst: Bereitstellen einer ersten Warnung als Folge des Erlangens der ersten Fehleranzeige.

11. Verfahren nach einem der vorhergehenden Ansprüche, wobei das Verfahren ferner den folgenden Schritt umfasst: Bereitstellen einer zweiten Warnung als Folge des Erlangens der zweiten Fehleranzeige.

12. Frequenzumrichter zum Betreiben einer elektrischen Maschine, wobei der Frequenzumrichter mindestens ein Messinstrument zum Durchführen der ersten und der zweiten Messung nach einem der vorhergehenden Ansprüche aufweist, **dadurch gekennzeichnet, dass** der Frequenzumrichter ein Computerprogramm aufweist, das zum Ausführen der Verfahrensschritte mindestens eines der vorhergehenden Ansprüche ausgelegt ist.

13. Frequenzumrichter nach Anspruch 12, der ferner eine Einrichtung zum Einspeisen eines Prüfsignals in eine Wicklung der Maschine aufweist.

## Revendications

1. Procédé de détection d'un défaut dans une machine électrique, le procédé comprenant les étapes suivantes :
- effectuer (30) au moins une première mesure sur la machine pendant un fonctionnement normal de la machine pour obtenir un premier ensemble de valeurs ;
- analyser (40) le premier ensemble de valeurs pour obtenir une première indication de défaut ;
- interrompre (70), en conséquence de l'obtention de la première indication de défaut, le fonctionnement normal de la machine ;
- choisir (60), sur la base du type de la première indication de défaut, une deuxième mesure parmi une pluralité de mesures alternatives ;
- effectuer (80) la deuxième mesure sur la machine lorsque le fonctionnement normal de la machine est interrompu pour obtenir un deuxième ensemble de valeurs ;
- analyser (90) le deuxième ensemble de valeurs pour obtenir une deuxième indication de défaut ; et
- déterminer, sur la base du fait que la deuxième indication de défaut est obtenue ou non, si le défaut est présent ou non ;
le procédé étant **caractérisé en ce qu'**il comprend les étapes suivantes :
- en conséquence de la non-obtention de la deuxième indication de défaut, reprendre (120) le fonctionnement normal de la machine et modifier (20) une condition (150) d'obtention de la première indication de défaut de telle sorte qu'une autre fausse première indication de défaut soit empêchée d'être obtenue.

2. Procédé selon l'une quelconque des revendications précédentes,
dans lequel la première mesure comprend l'une des mesures suivantes : une mesure de courant de phase dans un enroulement de stator, une mesure de vibration, une mesure de tension de phase et une mesure de vitesse.

3. Procédé selon l'une quelconque des revendications précédentes, dans lequel le défaut est l'un des suivants : un court-circuit entre spires dans un enroulement de stator, une barre de rotor cassée, un défaut de roulement et un défaut de refroidissement.

4. Procédé selon l'une quelconque des revendications précédentes, dans lequel l'étape d'analyse (40) du premier ensemble de valeurs comprend la transformation du premier ensemble de valeurs dans un domaine fréquentiel.

5. Procédé selon l'une quelconque des revendications précédentes, dans lequel la deuxième mesure est réalisée (80) lorsque la machine est à l'arrêt.

6. Procédé selon l'une quelconque des revendications précédentes, dans lequel le procédé comprend en outre l'étape comprenant d'injecter un signal de test dans un enroulement de la machine, et le deuxième ensemble de valeurs comprend une réponse au signal de test.

7. Procédé selon l'une quelconque des revendications précédentes, le procédé comprenant en outre l'étape suivante : effectuer (10) une mesure de référence sur la machine lorsque la machine est neuve ou autrement présumée sans défaut pour obtenir un ensemble de valeurs de référence.

8. Procédé selon la revendication 7, le procédé comprenant en outre l'étape suivante : comparer le premier ensemble de valeurs et/ou le deuxième ensemble de valeurs avec l'ensemble de valeurs de référence.

9. Procédé selon l'une quelconque des revendications précédentes, dans lequel au moins une étape du procédé est exécutée automatiquement par un programme informatique s'exécutant dans un convertisseur de fréquence faisant fonctionner la machine.

10. Procédé selon l'une quelconque des revendications précédentes, le procédé comprenant en outre l'étape suivante : fournir, en conséquence de l'obtention de la première indication de défaut, un premier avertissement.

11. Procédé selon l'une quelconque des revendications précédentes, le procédé comprenant en outre l'étape suivante : fournir, en conséquence de l'obtention de la deuxième indication de défaut, un deuxième avertissement.

12. Convertisseur de fréquence pour le fonctionnement d'une machine électrique, le convertisseur de fréquence comprenant au moins un instrument de mesure pour effectuer la première mesure et la deuxième mesure selon l'une quelconque des revendications précédentes, **caractérisé en ce que** le convertisseur de fréquence comprend un programme informatique configuré pour exécuter les étapes de procédé d'au moins une des revendications précédentes.

13. Convertisseur de fréquence selon la revendication 12, comprenant en outre des moyens pour injecter un signal de test dans un enroulement de la machine.
